# EUROPEAN PATENT APPLICATION

(11) **EP 4 593 067 A1**
(43) Date of publication of application: **30.07.2025**
(21) Application number: 23868456.7
(22) Date of filing: 06.09.2023
(51) Int. Cl.: H01L 21/67, H01S 5/183

(54) **HEATER BLOCK AND SUBSTRATE HEATING DEVICE INCLUDING SAME**

(30) Priority: 19.09.2022 KR 20220117597
(71) Applicant: AP Systems Inc., Hwaseong-si, Gyeonggi-do 18487 (KR)
(72) Inventor: LEE, Dae Ryong, Hwaseong-si, Gyeonggi-do 18505 (KR); MOON, Yong Soo, Hwaseong-si, Gyeonggi-do 18503 (KR); KIM, Sung Chul, Hwaseong-si, Gyeonggi-do 18483 (KR); JI, Sang Hyun, Yongin-si, Gyeonggi-do 16930 (KR); KIM, Chang Kyo, Hwaseong-si, Gyeonggi-do 18457 (KR)
(74) Representative: Michalski Hüttermann & Partner Patentanwälte mbB
(86) International application number: PCT/KR2023/013348
(87) International publication number: WO 2024/063402

(57) **Abstract**

The present invention relates to a heater block capable of precise control of a heating temperature and a substrate device including the heater block. The heater block may include: a first laser module having multiple laser cells; a second laser module which has multiple laser cells and is provided around the first laser module; and a first and a second power source part for independently supplying power to the first laser module and the second laser module, respectively, wherein, at least one among the first laser module and the second laser module is divided into multiple control areas each of which includes the one or more laser cells sharing an input terminal to which power is input, and the multiple control areas are controlled independently from each other.

## Description

### TECHNICAL FIELD

The present invention relates to a heater block and a substrate heating device including the same, and more particularly, to a heater block capable of precisely controlling a heating temperature and a substrate heating device including the same.

### BACKGROUND ART

A semiconductor device is typically manufactured by repeatedly performing unit processes for processing a substrate, such as ion implantation, thin-film deposition, and heat treatment, several times. The unit processes are required to process the substrate at a predetermined process temperature by supplying thermal energy. Particularly, since a heating process is performed in a short time when optical energy is used to heat the substrate to a predetermined process temperature, the heating process using the optical energy is widely used in that side effects such as impurities are minimally reduced.

In a conventional substrate heating device, heat treatment is performed through a heater block including a plurality of halogen lamps in a state in which the substrate is seated in the chamber, and a temperature of the substrate is measured in a non-contact manner using a temperature measuring device such as a pyrometer. The pyrometer may collect radiant energy emitted from the substrate and measure the temperature of the substrate in a non-contact manner based on a black body radiation temperature relationship. The temperature measured by the temperature measuring device is fed back to the heater block through a heating control unit to control a temperature of the heater block.

A silicon wafer has a translucent transmittance at a temperature of 600°C or less. When the silicon wafer having a characteristic of transmitting light in a low temperature range due to a material property thereof is used as the substrate, a portion of light emitted from a halogen lamp is transmitted through the substrate at a substrate temperature of 600°C or less. Here, as the pyrometer having a measurement wavelength band of 0.9 µm to 1 µm measures a portion of the light of the halogen lamp having a radiation wavelength of 0.4 µm to 6 µm, which is transmitted through the substrate, a temperature of only the substrate may not be accurately measured, and a temperature measurement error occurs.

Also, since the halogen lamps may not be divided into a plurality of control areas, the halogen lamp may not be further precisely controlled for each control area. Thus, a heater block controlled for each control area that is smaller than that of the halogen lamp is required.

(Patent Document 1) Korean Patent No. 10-0974013

### DISCLOSURE OF THE INVENTION

### TECHNICAL PROBLEM

The present invention provides a heater block capable of controlling a heating temperature for each of a plurality of subdivided control areas to improve temperature uniformity of a substrate and a substrate heating device including the same.

### TECHNICAL SOLUTION

A heater block according to an embodiment of the present invention may include: a first laser module having a plurality of laser cells; a second laser module having a plurality of laser cells and disposed around the first laser module; and a first and a second power source part configured to independently supply power to the first and second laser modules, respectively. Here, at least one of the first laser module and the second laser module is divided into a plurality of control areas each composed of one or more laser cells sharing an input terminal to which the power is inputted, and the plurality of control areas are controlled independently from each other.

The first laser module and the second laser module may have different divided shapes of the control areas.

The second laser module may be provided in plurality and arranged around the first laser module by using the first laser module as a center.

The first laser module may be divided into a central control area and an edge control area, and the second laser module may be bisected into a first control area and a second control area.

The first control area and the second control area may be disposed at different distances from the first laser module.

Each of the first control areas and the second control areas of the plurality of second laser modules may be respectively grouped according to the distances from the first laser module.

The first power source part may independently supply power to each of the central control area and the edge control area, and the second power source part may independently supply power to each of a group of the first control area and a group of the second control area.

Each of the first laser module and the second laser module may have a polygonal shape.

The laser cell may include a vertical-cavity surface-emitting laser (VCSEL).

The heater block may further include a reflector unit configured to reflect at least a portion of light emitted from the first laser module and the second laser module in a predetermined direction by surrounding an edge of each of the first laser module and the second laser module.

A substrate heating device according to another exemplary embodiment of the present invention may include: a substrate support configured to support a substrate; and the heater block according to an embodiment of the present invention, which is disposed to face the substrate support and heats the substrate by irradiating a first surface of the substrate with light.

The substrate heating device may further include a pyrometer disposed at a second surface side of the substrate, which is opposite to the first surface, to measure a temperature of the substrate.

The pyrometer may be provided in plurality, and the plurality of pyrometers may be disposed respectively corresponding to a plurality of virtual circles with different radii centered on the first laser module.

The substrate heating device may further include a heating control unit configured to control each of the control areas according to a distance from each of the virtual circles based on a temperature measured by each of the plurality of pyrometers.

A method for heating a substrate according to yet another exemplary embodiment of the present invention may include: providing a substrate to face a heater block including a first laser module and a second laser module, to which power is each independently supplied; irradiating a first surface of the substrate, which faces the heater block, with light by using the first laser module and the second laser module; and measuring a temperature of the substrate by using a pyrometer disposed at a second surface side of the substrate, which is opposite to the first surface. Here, at least one of the first laser module and the second laser module is divided into a plurality of control areas controlled independently from each other.

The first laser module may be divided into a central control area and an edge control area, the second laser module may be bisected into a first control area and a second control area, and the second laser module may be provided in plurality and arranged around the first laser module by using the first laser module as a center so that distances from the first laser module to each of the first control area and the second control area are different.

The method may further include grouping and controlling respectively the first control areas and the second control areas of the plurality of second laser modules according to the distances from the first laser module.

A plurality of pyrometers may be disposed respectively corresponding to a plurality of virtual circles with different radii centered on the first laser module according to the grouping of the first control areas and the second control areas, and the grouping and controlling may control each of the control areas for each group according to a distance from each of the virtual circles based on a temperature measured by each of the plurality of pyrometers.

### ADVANTAGEOUS EFFECTS

The heater block according to the embodiment of the present invention may control the first laser module and the second laser module independently from each other by independently supplying the power to each of the first laser module and the second laser module through the first and second power source parts. Thus, the heating temperature may be adjusted for each position of the first laser module and the second laser module, and the heating uniformity of the object to be heated such as a substrate may be improved. Also, as at least one of the first laser module and the second laser module is divided into the plurality of control areas and controlled independently from each other, the control areas may be subdivided, and the heating uniformity for the object to be heated may be further improved.

Here, as the divided shape of the control area between the first laser module and the second laser module is differentiated into concentric division and radial division, the heating temperature may be precisely controlled by subdividing the control area in the radial direction from the center of the heater block. Here, as the first control area and the second control area of the second laser module disposed around the first laser module are arranged at different distances from the first laser module, and the first control area and the second control area of the plurality of second laser modules are grouped according to the distance from the first laser module, the plurality of first control areas and the plurality of second control areas may be efficiently controlled for each group forming the concentric circle centered on the first laser module. Thus, the temperature uniformity of the object to be heated through the heating may be improved.

Also, a power consumption may be reduced in comparison with the conventional halogen lamps due to high energy efficiency by using a Vertical-Cavity Surface-Emitting Laser (VCSEL) in the laser cell, and an optical property may be effectively controlled due to the light straightness and the easiness of emitting light having a specific wavelength.

And the substrate heating device including the heater block of the present invention may improve the temperature uniformity of the substrate during the process by controlling the heating temperature of the first laser module and the second laser module using the temperature measured by the pyrometer. Particularly, as the control area is subdivided by dividing at least one of the first laser module and the second laser module into the plurality of control areas, the temperature uniformity of the substrate may be further improved. Here, the pyrometer is provided in plurality to provide the plurality of pyrometers so as to respectively correspond to the plurality of virtual circles having different radii that are different in distance from the first laser module, and the plurality of first control areas and the plurality of second control areas may be controlled for each group that forms a concentric circle centered on the first laser module by respectively grouping the first control area and the second control area of the plurality of second laser modules according to the distance from the first laser module. Through this, the plurality of first control areas and the plurality of second control areas may be precisely controlled for each group according to the distance from each virtual circle based on the temperatures respectively measured by the plurality of pyrometers, and thus the process characteristics such as excellent temperature uniformity of the substrate may be improved.

Meanwhile, when the Vertical-Cavity Surface-Emitting Laser (VCSEL) is used in the laser cell of the heater block, the temperature of the substrate may be accurately measured even in the low temperature area lower than 600°C by irradiating the laser having the main emission wavelength band different from the measurement wavelength band of the pyrometer, and the temperature of the substrate may be precisely controlled. Thus, the substrate may be prevented from being damaged by securing the temperature uniformity of the substrate and reliability of the low-temperature process at the temperature equal to or less than 600°C may be secured.

### BRIEF DESCRIPTION OF THE DRAWINGS

FIG. 1 is a schematic cross-sectional view illustrating a heater block according to an embodiment of the present invention.
FIG. 2 is a cross-sectional view illustrating division of a first laser module and a second laser module according to an embodiment of the present invention.
FIG. 3 is a cross-sectional view illustrating arrangement of the first laser module and the second laser module according to an embodiment of the present invention.
FIG. 4 is a view illustrating a reflector unit according to an embodiment of the present invention.
FIG. 5 is a schematic cross-sectional view illustrating a substrate heating device according to another embodiment of the present invention.
FIG. 6 is a cross-sectional view illustrating arrangement of a pyrometer according to another embodiment of the present invention.
FIG. 7 is a flowchart representing a method for heating a substrate according to yet another embodiment of the present invention.

### MODE FOR CARRYING OUT THE INVENTION

Hereinafter, specific embodiments will be described in more detail with reference to the accompanying drawings. The present invention may, however, be embodied in different forms and should not be construed as limited to the embodiments set forth herein. Rather, these embodiments are provided so that this disclosure will be thorough and complete, and will fully convey the scope of the present invention to those skilled in the art. In every possible case, like reference numerals are used for referring to the same or similar elements in the description and drawings. In the figures, the dimensions of layers and regions are exaggerated for clarity of illustration. Like reference numerals in the drawings denote like elements, and thus their description will be omitted.

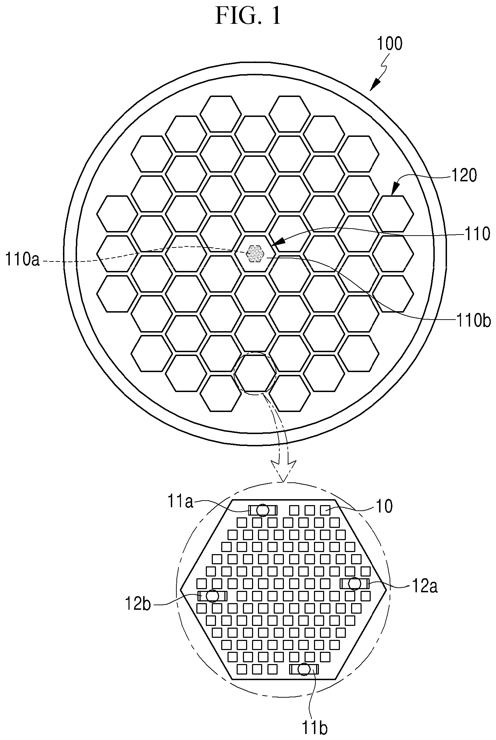

FIG. 1 is a schematic cross-sectional view illustrating a heater block according to an embodiment of the present invention.

Referring to FIG. 1, a heater block 100 according to an exemplary embodiment includes: a first laser module 110 including a plurality of laser cells 10; a second laser module 120 including the plurality of laser cells 10 and disposed around the first laser module 110; and a first and a second power source part 130 and 140 independently supplying power to the first laser module 110 and the second laser module 120, respectively.

The first laser module 110 may include the plurality of laser cells 10 and provide optical energy for heating. For example, the first laser module 110 may be disposed (or positioned) at a center (portion) of the heater block 100, and the plurality of laser cells 10 may be arranged in two-dimension to form an array. Here, the plurality of laser cells 10 may include semiconductor laser diodes, respectively, and be formed in the form of a single chip or formed by mounting a plurality of chips.

The second laser module 120 may include a plurality of laser cells 10, provide optical energy for heating as with the first laser module 110, and be disposed around the first laser module 110. For example, in the second laser module 120, the plurality of laser cells 10 may be arranged in two-dimension to form an array, and the plurality of laser cells 10 each including a semiconductor laser diode may be formed in the form of a single chip or formed by mounting a plurality of chips. Here, although the second laser module 120 may have the same laser cells 10, the same number of laser cells 10, and the same arrangement (form) of the laser cells 10 as the first laser module 110, the exemplary embodiment is not limited thereto. The second laser module 120 may have various configurations as long as the second laser module 120 is capable of effectively providing optical energy for heating.

Here, the second laser module 120 may be disposed around the first laser module 110. Specifically, the second laser module 120 may be provided around the first laser module 110 disposed at the center of the heater block 100 and disposed at an edge (portion) of the heater block 100.

Each of the first laser module 110 and the second laser module 120 may have various shapes such as a polygon such as a square or hexagon, a circle, an oval, or an arc.

The first and the second power source part 130 and 140 may independently supply power to the first laser module 110 and the second laser module 120, respectively. The first power source part 130 may supply power to the first laser module 110, and the second power source part 140 may supply power to the second laser module 120. Through this, the first laser module 110 and the second laser module 120 may be independently controlled. That is, each of the first laser module 110 and the second laser module 120 may have an independent power (source part).

For example, the first laser module 110 may be disposed at the center of the heater block 100 to heat (mainly) a center (portion) of an object to be heated such as a substrate 50, and the second laser module 120 may be disposed at the edge of the heater block 100 to heat (mainly) an edge (portion) of the object to be heated. Here, while (almost) no heat loss occurs in the center portion of the object to be heated because the center portion of the object to be heated is surrounded by the edge that is heated by the second laser module 120, heat loss may occur in the edge of the object to be heated because an outer portion of the edge of the object to be heated is exposed to vacuum or air. Accordingly, when the object to be heated is heated by controlling the first laser module 110 and the second laser module 120 at the same heating temperature, the edge of the object to be heated may have a temperature less than that of the center portion of the object to be heated, and temperature non-uniformity may occur between the center and the edge of the object to be heated.

Thus, the heater block 100 according to the present invention may individually and independently supply power to the first laser module 110 and the second laser module 120 through the first power source part 130 and the second power source part 140 to control the first laser module 110 and the second laser module 120 independently from each other. Accordingly, each of the center portion and the edge portion of the object to be heated may be (independently) heated by controlling the heating temperatures of the first laser module 110 and the second laser module 120 to improve heating uniformity of the object to be heated such as the substrate 50.

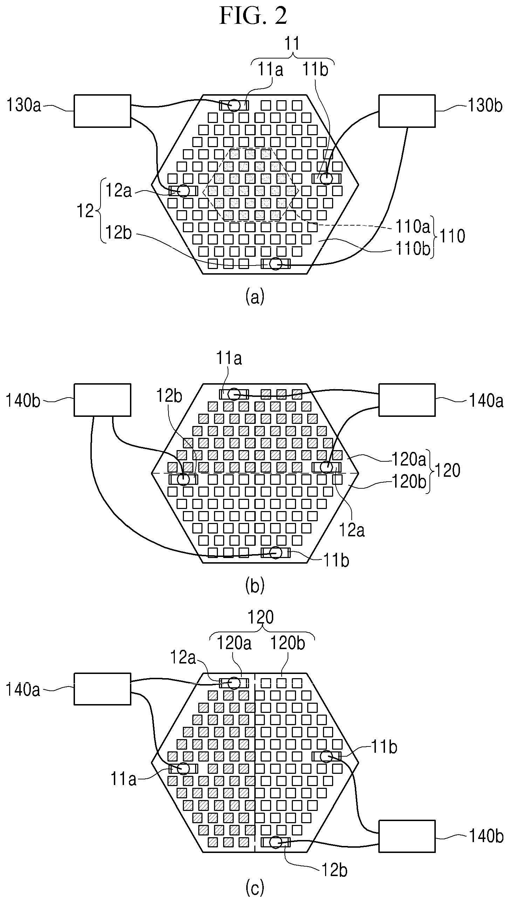

FIG. 2 is a cross-sectional view illustrating division of the first laser module and the second laser module according to an embodiment of the present invention. Here, (a) of FIG. 2 illustrates the division of the first laser module, (b) of FIG. 2 illustrates first-type division of the second laser module, and (c) of FIG. 2 illustrates second-type division of the second laser module.

Referring to FIG. 2, at least one laser module 110 and/or 120 of the first laser module 110 and the second laser module 120 may be divided into a plurality of control areas 110a and 110b and/or 120a and 120b each composed of one or more laser cells 10 sharing input terminals 11 and 12 to which power is supplied, and the plurality of control areas 110a and 110b or 120a and 120b may be independently controlled. At least one laser module 110 and/or 120 of the first laser module 110 and the second laser module 120 may include a plurality of (external) input terminals 11 and 12 to which the power is supplied from the outside (i.e., the first power source part and/or the second power source part). Here, the laser cell(s) 10 sharing the same input terminals 11 and 12 among the plurality of input terminals 11 and 12 may be divided into the plurality of control areas 110a and 110b and/or 120a and 120b, and the laser cell(s) 10 of one control area 110a or 110b and/or 120a or 120b and the laser cell(s) 10 of another control area 110b or 110a and/or 120b or 120a may be electrically connected to different input terminals 11 and 12.

That is, at least one laser module 110 and/or 120 of the first laser module 110 and the second laser module 120 may be divided into a plurality of control areas 110a and 110b and/or 120a and 120b having different input terminals 11 and 12, and the laser cell(s) 10 in respective control areas 110a, 110b, 120a, and 120b may share the same input terminal 11 or 12. Thus, the plurality of control areas 110a and 110b and/or 120a and 120b may include one or more laser cells 10 sharing each input terminal 11 or 12, and the input terminal 11 or 12 may be independently controlled according to whether the power is supplied.

Here, the first laser module 110 and the second laser module 120 may have the same or different number of control areas 110a, 110b, 120a, and 120b. Also, as only one laser module 110 or 120 of the first laser module 110 and the second laser module 120 is divided, the divided laser module 110 or 120 may have two or more control areas 110a and 110b or 120a and 120b, and as the entire laser module 120 or 110 is the control area, the non-divided laser module 110 or 120 may have single control area 120a or 110a.

Here, the input terminals 11 and 12 may include a positive (+) (electrode) terminal 11 and a negative (-) (electrode) terminal 12. For example, one control area 110a or 110b or 120a or 120b may include at least one laser cell 10 sharing a first positive terminal 11a and a first negative terminal 12a, and the other control area 110b or 120a or 120b or 110a may include at least one laser cell 10 sharing a second positive terminal 11b and a second negative terminal 12b.

Thus, the heater block 100 according to the present invention may divide at least one laser module 110 and/or 120 of the first laser module 110 and the second laser module 120 into the plurality of control areas 110a and 110b and/or 120a and 120b and control the divided control areas independently from each other to subdivide the control areas 110a, 110b, 120a, and 120b, thereby further improving heating uniformity of the object to be heated.

Here, the first laser module 110 and the second laser module 120 may have different division shapes of the control areas 110a, 110b, 120a, and 120b. The division shapes may include non-divided shapes. The different division shapes may include a case in which at least one of the first laser module 110 and the second laser module 120 is divided, and the other is not divided.

For example, when all of the first laser module 110 and the second laser module 120 are divided, the first laser module 110 may be divided concentrically and the second laser module 120 may be divided radially. Here, the concentric division refers to a feature of dividing a center of an object to be divided (e.g., the first laser module) concentrically (i.e., the same center) so that the inside and the outside are divided based on a line parallel to an edge of the object to be divided, which forms a virtual figure having the same shape as the object to be divided, and the radial division refers to a feature of dividing both sides of a line (or lines) contacting an edge of an object to be divided (e.g., the second laser module) based on the line (or lines) passing through a center of the object to be divided and contacting the edge of the object to be divided. Here, when the second laser module 120 has a circular shape, both sides may be divided based on a diameter (or radius) of the circle. Also, when the second laser module 120 has a polygonal shape with an even number of angles, the both sides may be divided based on a line connecting a side (a center thereof) and a side (a center thereof) or a line connecting a vertex and a vertex of the polygon, and when the second laser module 120 has a polygonal shape with an odd number of angles, the both sides may be divided based on a line connecting a vertex and a center of a side of the polygon.

The first laser module 110 may be disposed at the center of the heater block 100 and divided concentrically, and the second laser module 120 may be disposed at the edge of the heater block 100 and may be divided radially. Through this, the heating temperature may be precisely controlled for each control area 110a, 110b, 120a, and 120b by subdividing the control areas 110a, 110b, 120a, and 120b according to a distance from the center of the heater block 100.

Thus, the heater block 100 according to the present invention may be subdivided in a radial direction from the center of the heater block 100 to precisely control the heating temperature by differentiating the division shapes of the control areas 110a, 110b, 120a, and 120b between the first laser module 110 and the second laser module 120 into concentric division and radial division.

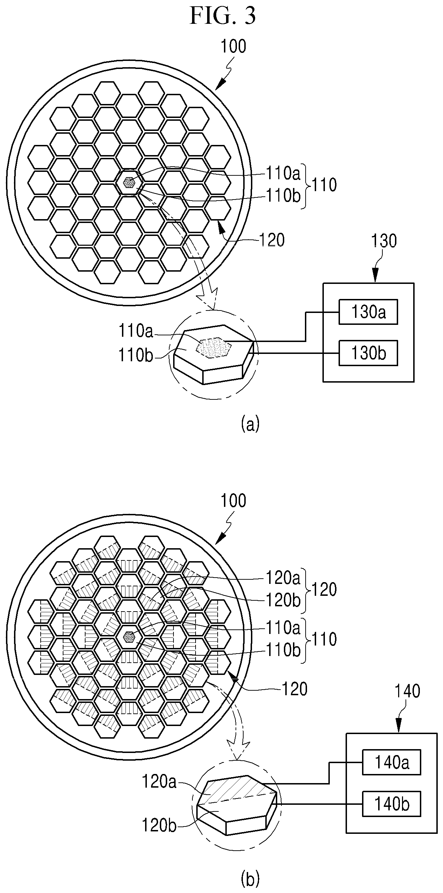

FIG. 3 is a cross-sectional view illustrating arrangement of the first laser module and the second laser module according to an embodiment of the present invention. Here, (a) of FIG. 3 illustrates an exemplary embodiment in which only the first laser module is divided, and (b) of FIG. 3 illustrates another exemplary embodiment in which all of the first laser module and the second laser module are divided.

Referring to FIG. 3, the second laser module 120 may be provided in plurality and arranged around the first laser module 110 by using the first laser module 110 as a center. That is, the second laser modules 120 may surround the first laser module 110 along a circumference of the first laser module 110. For example, only one first laser module 110 may be disposed at the center (or central portion) of the heater block 100, and the plurality of second laser modules 120 may be disposed at the edge of the heater block 100 to surround the circumference of the first laser module 110. Here, although the second laser module 120 may surround the first laser module 110 with only one shell, the second laser module 120 may surround the first laser module 110 with multiple shells such as a double shell and triple shell which form a concentric circle around the first laser module 110 as illustrated in FIG. 3 according to a size and shape of the object to be heated and/or the heater block 100. Through this, the control areas 110a, 110b, 120a, and 120b may be subdivided in the radial direction from the center of the heater block 100. Also, the second power source part 140 may independently supply power to each of the plurality of second laser modules 120 or commonly supply power to the plurality of second laser modules 120. Here, the second power source part 140 may include a plurality of power supply parts or one power supply part from which power is distributed to the plurality of second laser modules 120.

Here, the first laser module 110 may be divided into a central control area 110a and an edge control area 110b, and the second laser module 120 may be bisected into a first control area 120a and a second control area 120b. For example, the first laser module 110 may be concentrically divided into the central control area 110a and the edge control area 110b as illustrated in (a) of FIG. 2. Here, the central control area 110a may be disposed at the inside and disposed at the center of the heater block 100, and the edge control area 110b may be disposed at the outside of the central control area 110a. Thus, the control areas 110a and 110b may be subdivided in the radial direction from the center of the heater block 100 even in the first laser module 110.

The second laser module 120 may be radially bisected into the first control area 120a and the second control area 120b, the first control area 120a and the second control area 120b may be symmetric to each other, and shapes, surface areas, and the number of the laser cells 10 may be equal to each other. For example, when the second laser module 120 has a hexagonal shape, the second laser module 120 may be bisected into the first control area 120a and the second control area 120b based on a line connecting the vertices as illustrated in (b) of FIG. 2 or bisected into the first control area 120a and the second control area 120b based on a line connecting the sides as illustrated in (c) of FIG. 2. Although the first control area 120a and the second control area 120b may be divided (or bisected) based on a line connecting the center of the side and the center of the side as illustrated in (c) of FIG. 2, the first control area 120a and the second control area 120b may be divided based on a line connecting a side and a side which are inclined to form a predetermined angle with the line connecting the center of the side and the center of the side.

Here, the first control area 120a and the second control area 120b may be disposed at different distances from the first laser module 110 as illustrated in (b) of FIG. 3. Here, one control area 120a or 120b of the first control area 120a and the second control area 120b may be disposed close to the first laser module 110, and the other control area 120b or 120a may be disposed away from the first laser module 110.

For example, the plurality of second laser modules 120 may be disposed around the first laser module 110 so that the first control area 120a is disposed close to the first laser module 110 toward the first laser module 110, and the second control area 120b is disposed relatively far from the first laser module 110 (in a radius direction). Here, the first control area 120a may divide (or bisect) the second laser module 120 based on a line passing through a center of the second laser module 120 parallel to a tangent line of a (concentric) circle centered on the first laser module 110 for each (arrangement) position of the second laser module 120. However, the exemplary embodiment is not limited thereto. For example, the second laser module 120 may be divided into the first control area 120a and the second control area 120b as long as the second laser module 120 is arranged so that the first control area 120a faces the first laser module 110.

The first power source part 130 may include a central power supply part 130a supplying power to the central control area 110a and an edge power supply part 130b supplying power to the edge control area 110b, and the second power source part 140 may include a first power supply part 140a supplying power to the first control area 120a and a second power supply part 140b supplying power to the second control area 120b. Here, the central power supply part 130a may supply power to the central control area 110a, and the edge power supply part 130b may supply power to the edge control area 110b. Through this, since each of the central control area 110a and the edge control area 110b has the independent power supply (part), the central control area 110a and the edge control area 110b may be controlled independently from each other.

Also, the first power supply part 140a may supply power to the first control area 120a, and the second power supply part 140b may supply power to the second control area 120b. Through this, as each of the first control area 120a and the second control area 120b has the independent power supply (part), the first control area 120a and the second control area 120b may be controlled independently from each other. Here, the first power supply part 140a may supply power to each of the first control areas 120a of the plurality of second laser modules 120. For example, the first power supply part 140a may independently supply power to each of the first control areas 120a or commonly supply power to two or more groups of the first control areas 120a by grouping two or more first control areas 120a. Also, the second power supply part 140b may supply power to each of the second control areas 120b of the plurality of second laser modules 120. For example, the second power supply part 140b may independently supply power to each of the second control areas 120b or commonly supply power to two or more groups of the second control areas 120b by grouping two or more second control areas 120b.

Here, the first control areas 120a and the second control areas 120b of the plurality of second laser modules 120 may be respectively grouped according to distances from the first laser module 110 and controlled (simultaneously) for each group. Here, the first control areas 120a and the second control areas 120b of the plurality of second laser modules 120 may be grouped by two or more (or two or more first control areas and two or more second control areas) according to the distances from the first laser module 110 and controlled for each group disposed at different distances from the first laser module 110 (of the plurality of first control areas and second control areas). For example, a plurality of first control areas 120a disposed at the same or similar distance from the laser module 110 may be grouped, and a plurality of second control areas 120b disposed at the same or similar distance from the laser module 110 may be grouped. Here, the first control area(s) 120a or the second control area(s) 120b, which forms a concentric circle around the first laser module 110 or passing through (or crossing) the same concentric circle (having the same radius) may be grouped. Here, the first control area(s) 120a(s) and the second control area(s) 120b, which forms each group, may be (electrically) connected to each other.

For example, the first control area(s) 120a of the second laser module(s) 120 of the same shell may be grouped, and the second control area(s) 120b of the second laser module(s) 120 of the same shell may be grouped. That is, the first control area(s) 120a and the second control area(s) 120b of the second laser module(s) 120 of a first shell (or layer) may be grouped, and the first control area(s) 120a and the second control area(s) 120b of the second laser module(s) 120 of the double shell may be grouped. Here, the first control area(s) 120a or the second control area(s) 120b of the second laser module(s) 120 of n-layer shell (up to) according to the number of layers (or shells) of the second laser module 120 surrounding the first laser module 110 may be grouped.

Also, when the second laser module 120 is not divided, two or more second laser modules 120 disposed at the same or similar distance from the first laser module 110 may be grouped, and the second laser module(s) 120 that forms a concentric circle around the first laser module 110 or passes through the same concentric circle may be grouped.

Also, the first power source part 130 may independently supply power to the central control area 110a and the edge control area 110b, and the second power source part 140 may independently supply power to each of the group of the first control areas 120a and the group of the second control areas 120b. The first power source part 130 may independently supply power to each of the central control area 110a and the edge control area 110b, the central power supply part 130a of the first power source part 130 may supply power to the central control area 110a, and the edge power supply part 130b of the first power source part 130 may supply power to the edge control area 110b. Through this, each of the central control area 110a and the edge control area 110b may be controlled independently from each other.

The second power source part 140 may independently supply power to each of the group of the first control areas 120a and the group of the second control areas 120b, the first power supply part 140a of the second power source part 140 may supply power to the group of the first control areas 120a, and the second power supply part 140b of the second power source part 140 may supply power to the second control areas 120b. Through this, each of the group of the first control areas 120a and the group of the second control areas 120b may be controlled independently, and the heating temperature may be controlled for each group of the plurality of first control areas 120a and second control areas 120b disposed at different distances from the first laser module 110.

For example, the plurality of first control areas 120a and the plurality of second control areas 120b may be electrically connected for each group. Here, the first power supply part 140a may be provided in plurality to supply power to each group of the first control areas 120a, and the second power supply part 140b may be also provided in plurality to supply power to each group of the second control areas 120b. The first power supply part 140a may supply power to each group of the first control areas 120a by distributing power from one first power supply part 140a, the second power supply part 140b may also supply power to each group of the first control areas 120a by distributing power from one second power supply part 140b, and a switching unit (not shown) may be provided for each distribution line and controlled for each group.

Thus, the heater block 100 according to the present invention may group the first control areas 120a and the second control areas 120b of the plurality of second laser modules 120 according to the distances from the first laser module 110 by arranging at different distances from the first laser module 110 the first control area 120a and the second control area 120b of the plurality of second laser modules 120 surrounding along the circumference of the first laser module 110 the first laser module 110. Through this, the plurality of first control areas 120a and the plurality of second control areas 120b (i.e., (each) group of the first control areas and (each) group of the second control areas) may be efficiently (or effectively) controlled for each group that forms a concentric circle centered on the first laser module 110 or passes through the same concentric circle, and temperature uniformity of the object to be heated through heating may be improved.

Here, each of the first laser module 110 and the second laser module 120 may have a polygonal shape, and edges of each of the first laser module 110 and the second laser module 120 may form a polygonal shape. Here, the second laser module 120 may be disposed at each of sides of the first laser module 110, and the side of the first laser module 110 and a side of the second laser module 120 may be arranged in parallel to each other.

Since the first laser module 110 and the second laser module 120 are variously arranged according to a size and shape of the object to be heated (e.g., a substrate), an area provided by the first laser module 110 and the second laser module 120 in the heater block 100 needs to be expanded. Also, since emission of light (i.e., irradiation of laser) in a spaced space does not occur when the spaced space is generated between the first laser module 110 and the second laser module 120 and/or between the plurality of second laser modules 120 due to a reflector unit 150, the spaced space inevitably exhibits a light emission state and a temperature distribution different from those of a portion in which the first laser module 110 and/or the second laser module 120 are disposed. Due to the above-described reason, the spaced space (or spaced distance) between the first laser module 110 and the second laser module 120 and/or between the plurality of second laser modules 120 is required to be two-dimensionally and constantly maintained. To this end, each of the first laser module 110 and the second laser module 120 may have a polygonal shape. When each of the first laser module 110 and the second laser module 120 have the polygonal shape, the spaced space may be uniformly secured on an entire (emission) surface of the heater block 100 by two-dimensionally arranging the first laser module 110 and the second laser module 120 so that respective sides of the first laser module 110 and the second laser module 120 are adjacent in parallel to each other. On the other hand, when each of the first laser module 110 and the second laser module 120 has a circular shape, the first laser module 110 and the second laser module 120 inevitably exhibit different spaced distances (or spaced spaces) depending on directions in case of two-dimensional arrangement.

Also, the first laser module 110 and the second laser module 120 may have the same shape (or form). When the first laser module 110 and the second laser module 120, which need to be expanded according to the shape and size of the object to be heated, have the same shape, a planar heating body (i.e., the heater block) may be formed by simply arranging (or assembling) the first laser module 110 and the plurality of second laser modules 120 on a plane.

For example, each of the first laser module 110 and the second laser module 120 may have a hexagonal shape, and one second laser module may be disposed on each side of the first laser module 110 so that the sides are adjacent in parallel to each other. When the object to be heated is a circular substrate 50 such as a wafer, the heater block 100 may have a circular shape depending on a shape of the substrate 50, and the first laser module 110 and the plurality of second laser modules 120 may be arranged so that an outline of the arrangement (form) of the first laser module 110 and the plurality of second laser modules 120 has a shape similar to the circular shape in terms of temperature uniformity of the object to be heated. Here, when the edge of each of the first laser module 110 and the second laser module 120 has a hexagonal shape, the first laser module 110 and the second laser module 120 may be easily expanded according to the size and shape of the object to be heated while maintaining the overall spaced space uniformly, and the outline of the arrangement (form) of the first laser module 110 and the plurality of second laser modules 120 may have a shape similar to the circular shape. Here, the heater block 100 corresponding to a 4-inch wafer may include one hexagonal first laser module 110 and six hexagonal second laser modules 120 disposed on the sides of the first laser module 110, respectively. Also, the heater block 100 corresponding to a 12-inch wafer may include one hexagonal first laser module 110 and sixty hexagonal second laser modules 120 disposed around the first laser module 110. Here, the sixty second laser modules 120 may surround the circumference of the first laser module with four shells including a first shell including six second laser modules 120, a double shell including twelve second laser modules 120, a triple shell including eighteen second laser modules 120, and a quadruple shell including twenty four second laser modules 120.

On the other hand, a honeycomb structure formed by arranging the hexagonal first laser module 110 and the plurality of second laser modules 120 may include minimum (or minimum number of) (same as the number of angles) second laser modules 120 including the vertices of the first laser module 110 to surround the entire circumference of the first laser module 110. Thus, while the number of second laser modules 120 may be reduced to a minimum value, a (average) density of the laser cells 10 (per unit area) may be increased, and a production cost (or manufacturing cost) of the heater block 100 may be reduced to increase a light emitting efficiency (or heating efficiency).

Also, when the plurality of second laser modules 120 are arranged in parallel to each side of the first laser module 110, in case of a polygon such as a triangle, a rectangle, and a pentagon, which have fewer angles than the hexagon, the number of second laser modules 120, which is obtained by adding the number of vertices to the number of sides, (or two times of the number of angles) is required to surround empty vertices because each vertex is empty. In case of a polygon with more angles than the hexagon, although the same number of second laser modules 120 surround the entire circumference of the first laser module 110, the number of the second laser modules 120 may be greater than that of the second laser modules 120 surrounding the entire circumference of the hexagonal first laser module 110. For example, eight rectangular second laser modules 120 are required to surround the rectangular first laser module 110 including vertices thereof, and ten pentagonal second laser modules 120 are required to surround the pentagonal first laser module 110 including vertices thereof. Also, in case of the triangular first laser module 110 and the triangular second laser module 120, two times of the number of angles is **6,** which is equal to the number of second laser modules 120 surrounding the hexagonal first laser module 110. In order to surround the triangular first laser module 110 including vertices thereof with only six second laser modules 120, the second laser modules 120 are irregularly arranged, and the side of each second laser module 120 is not (mostly) adjacent to each other. In this case, a density of the laser cell 10 is increased, and the light emitting efficiency is degraded.

However, in the honeycomb structure formed by arranging the hexagonal first laser module 110 and the plurality of hexagonal second laser modules 120, the second laser modules 120 may be regularly arranged with only six second laser modules 120, and the sides of the second laser modules 120 may also be adjacent to each other. Thus, the density of the laser cell 10 may be increased, and the light emitting efficiency may be improved.

The laser cell 10 may include a vertical-cavity surface-emitting laser (VCSEL).

A semiconductor laser diode used in the laser cell 10 may be largely divided into an edge-emitting laser (EEL) and the VCSEL depending on light emitting methods. The VCSEL has a structure of emitting a laser beam in a direction perpendicular to the object to be heated such as the substrate 50, unlike a side-emitting laser such as an existing distributed feedback laser diode (DFB LD) or a fabri-perot laser diode (FP LD). Since the laser beam is emitted in the direction perpendicular to the object to be heated, the VCSEL may have a circular symmetry distribution and superior optical uniformity than that of the side-emitting laser. Since a wafer scale process and a manufacturing using a single silicon wafer (or circular substrate) may be performed, a low-cost laser manufacturing may be performed. Also, since a resonance distance is extremely short, critical current may be reduced and an overall output may be reduced.

Particularly, a surface light source having a wide area is required to be used as a heating light source in a substrate heating device 200. To this end, the laser cells 10 are required to be manufactured as a two-dimensional array-type parallel light source. Since the side-emitting laser emits light through a side of a structure laminated on a substrate, it is difficult to manufacture the laser cell 10 as the two-dimensional array-type parallel light source. However, since the VCSEL only needs to form the structure laminated on the substrate into a desired structure, the desired two-dimensional array-type parallel light source may be extremely easily manufactured.

Also, since the VCSEL has a light source irradiation angle of about 20° to about 25° with respect to a direction perpendicular to a light emitting surface, which is extremely narrower than an irradiation angle of 30° to 40° which a light emitting diode (LED) has, the VCSEL has excellent light straightness. Due to this, the two-dimensional array-type parallel light source capable of irradiating high-output and high-precision light onto the object to be heated but also emitting uniform light may be manufactured.

For example, the VCSEL may be configured by laminating a mirror layer, an active layer, and a mirror layer on the substrate to vertically emit a laser beam. Here, in case of a short wavelength of a 850 nm band, gallium arsenide (GaAs) may be used as the substrate, and a distributed bragg reflector (DBR) in which low and high refractive indices are alternately grown through aluminum (Al) composition variation of aluminum gallium arsenide (AlGaAs) lattice matched to gallium arsenide (GaAs) may be used as the mirror layer. Also, the active layer may (mainly) use a gallium arsenide (GaAs) multi-quantum well structure to generate light having a desired wavelength.

Since the first laser module 110 and the second laser module 120 may be provided in parallel to each other so that a distance between the light emitting surface and the substrate 50 is constant to uniformly heat the substrate 50 that is the object to be heated, the first laser module 110 and the second laser module 120 may be provided as the surface light source having a size corresponding to that of the substrate 50. To this end, the first laser module 110 and the second laser module 120, in which the laser cells 10 including the VCSEL are arranged in a two-dimensional array, are arranged such that the second laser modules 120 are at the circumference of the first laser module 110 by using the first laser module 110 as the center, and the plurality of second laser modules 120 may be provided in correspondence to the size of the substrate 50.

Thus, the heater block 100 according to the present invention may reduce power consumption in comparison with a conventional halogen lamp by using the VCSEL in the laser cell 10 and effectively control an optical property due to light straightness and easiness of emitting light having a specific wavelength.

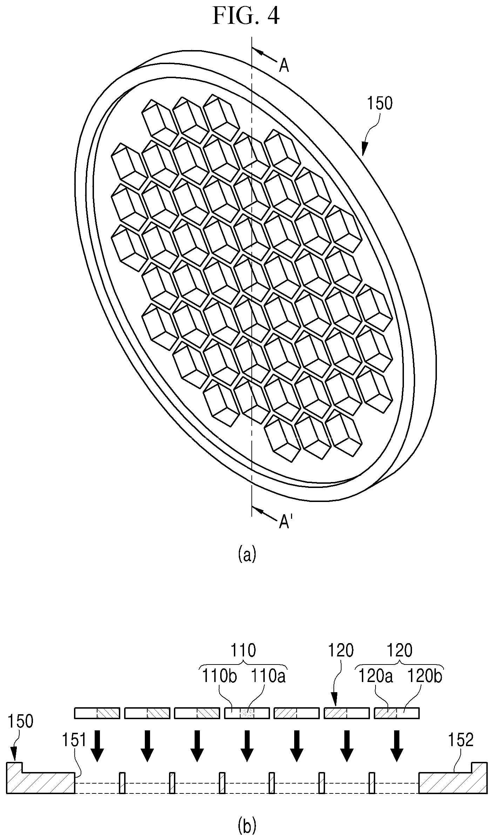

FIG. 4 is a view illustrating a reflector unit according to an embodiment of the present invention. Here, (a) of FIG. 4 is a perspective view illustrating the reflector unit, and (b) of FIG. 4 is a cross-sectional view obtained by cutting the reflector unit along line A-A'.

Referring to FIG. 4**,** the heater block 100 according to the present invention may further include a reflector unit 150 that surrounds the edge of each of the first laser module 110 and the second laser module 120 to reflect at least a portion of light emitted from the first laser module 110 and the second laser module 120 in a predetermined direction.

The reflector unit 150 may surround the edge of each of the first laser module 110 and the second laser module 120 to reflect at least a portion of the light emitted from the first laser module 110 and the second laser module 120 in a predetermined direction and reflect at least a portion of the emitted light toward the object to be heated.

Although the laser cell 10 is superior to a light emitting diode (LED) in terms of the light straightness, the laser cell 10 may not emit light completely perpendicular to the light emitting surface and has an irradiation angle of 20° to 25°. Thus, a portion of the light emitted from the laser cell 10 is not incident into the object to be heated due to a high angle. Thus, an optical efficiency may be maximized by reflecting diffused light of the light emitted from the first laser module 110 and the second laser module 120 toward the object to be heated using the reflector unit 150.

For example, the reflector unit 150 may have a plate shape and include recessed portions or through-portions into which the first laser module 110 and the second laser module 120 are inserted and mounted, respectively. Here, the reflector unit 150 may include a side part that defines the recessed portions or through-portions and is inclined with respect to the light emitting surface of each of the first laser module 110 and the second laser module 120 and a front part connected to the side part and parallel to the light emitting surface of each of the first laser module 110 and the second laser module 120. Here, the side part of the reflector unit 150 may form an inclined reflection surface 151 that reflects the light emitted and diffused from the first laser module 110 and the second laser module 120 toward the object to be heated, and the front part of the reflector unit 150 may form a front reflection surface 152 that reflects, toward the object to be heated, light incident again toward the heater block 100 as a portion of light emitted from the first laser module 110 and the second laser module 120 is reflected by the object to be heated. Here, the inclined reflection surface 151 may form an inclination angle of 80° to 90° with respect to the light emitting surface of each of the first laser module 110 and the second laser module 120.

Since the laser cell 10 has an irradiation angle (or emission angle) of 20° to 25° with respect to the direction perpendicular to the light emitting surface, diffused light may be effectively reflected toward the object to be heated when the inclination angle of the inclined reflection surface 151 with respect to the light emitting surface is 80° to 90°. As light having an irradiation angle of 20° to 25° is obliquely incident into and reflected by the inclined reflection surface 151 having an inclination angle of 80° to 90°, the light may be focused and incident to the object to be heated at a high angle. On the other hand, since light is incident into and reflected by the inclined reflection surface 151 at a high angle in case of the LED having an irradiation angle of 30° to 40° with respect to the direction perpendicular to the light emitting surface, optical energy may not be effectively transmitted to the object to be heated when light is incident into the object to be heated obliquely at a low angle and reflected again.

When the inclined reflection surface 151 has an inclination angle less than 80° with respect to the light emitting surface of each of the first laser module 110 and the second laser module 120, the light emitted from the laser cell 10 and having excellent light straightness directly travels toward the object to be heated instead of being irradiated to the inclined reflection surface 151. Thus, as the light is not incident into the object to be heated at the high angle, light uniformity may be degraded. On the other hand, when the inclined reflection surface 151 has an inclination angle greater than 90° with respect to the light emitting surface of each of the first laser module 110 and the second laser module 120, the inclined reflection surface 151 faces the first laser module 110 and/or the second laser module 120. Thus, as the reflected light travels again toward the first laser module 110 and/or the second laser module 120, optical loss occurs.

Also, the inclined reflection surface 151 and/or the front reflection surface 152 may be coated with a metal reflection film to further increase a reflection efficiency. A body part of the reflector unit 150 may be made of an aluminum alloy having excellent thermal conductivity and mechanical strength, and the inclined reflection surface 151 and/or the front reflection surface 152 may form a mirror surface through polishing. However, micro-structures may still exist on a surface that causes diffused reflection even after polishing. Due to this reason, the reflection efficiency may be further increased by coating the inclined reflection surface 151 and/or the front reflection surface 152 with the metal reflection film. Although the metal reflection film may be made of gold (Au) or aluminum (Al), the exemplary embodiment is not limited to the material of the metal reflection film. For example, the metal reflection film may be made of a metal material that is stable at a high temperature and performs mirror reflection.

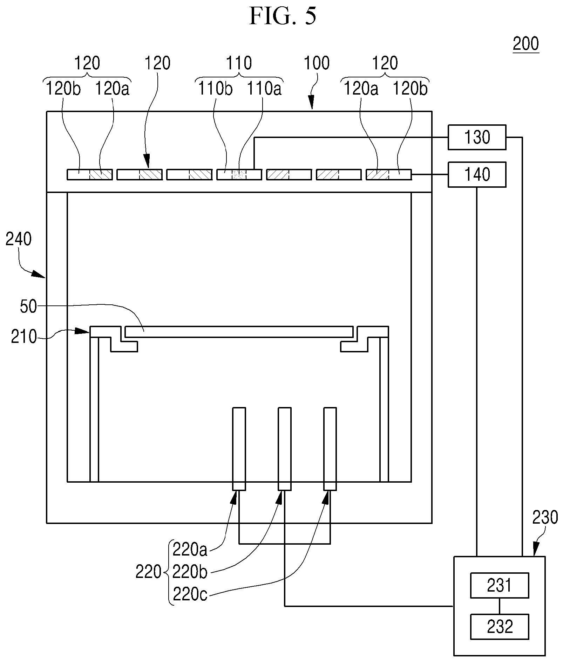

FIG. 5 is a schematic cross-sectional view illustrating a substrate heating device according to another embodiment of the present invention.

Hereinafter, the substrate heating device according to another exemplary embodiment of the present invention will be described in more detail with reference to FIG. 5, and features duplicated with those described in the heater block according to an embodiment of the present invention will be omitted.

A substrate heating device 200 according to another exemplary embodiment of the present invention may include: a substrate support 210 supporting a substrate 50; and the heater block 100 according to an embodiment of the present invention, which faces the substrate support 210 and heats the substrate 50 by irradiating light to a first surface of the substrate 50.

The substrate support 210 may support the substrate 50, i.e., an edge of a bottom surface of the substrate 50. Thus, a portion (or region) that is not in contact with the substrate support 210 in the bottom surface of the substrate may be exposed. For example, the substrate support 210 may have a hollow shape with an opened central portion. Thus, when the substrate 50 is seated on the substrate support 210, the edge of the bottom surface of the substrate 50 may be in contact with the substrate support 210, and the rest may be exposed downward.

The heater block 100 may be the heater block 100 in accordance with an exemplary embodiment. The heater block 100 may face the substrate support 210 and heat the substrate 50 by irradiating the first surface (e.g., top surface) with light (i.e., laser).

Here, the heater block 100 may serve to supply thermal energy to the substrate 50, and the first laser module 110 and the second laser module 120 may irradiate the first surface of the substrate 50 with light. Here, as the heater block 100 is spaced upward from the substrate support 210, optical energy generated by the first laser module 110 and the second laser module 120 may be transmitted through the first surface of the substrate 50 seated on the substrate support 210 to heat the substrate 50.

For example, the first laser module 110 and the second laser module 120 may provide the optical energy for heating the substrate 50 and be installed in a plurality of mounting grooves, respectively. The first laser module 110 and the second laser module 120 may be spaced apart from each other, and an arrangement structure and an installation structure of the first laser module 110 and the second laser module 120 may be variously changed according to a shape and size of the substrate 50.

Also, the heater block 100 may further include a window (not shown) disposed on the first laser module 110 and the second laser module 120. The window (not shown) may be disposed on the first laser module 110 and the second laser module 120 and between the substrate 50 and the first and second laser modules 110 and 120. Due to this, the window (not shown) may serve to transmit light emitted from the first laser module 110 and the second laser module 120 so as to the optical energy generated from the first laser module 110 and the second laser module 120 is provided to the substrate 50.

The substrate heating device 200 according to the present invention may heat the substrate 50 for various processes such as a process of performing thermal treatment on the substrate 50 or a process of forming a thin-film on the substrate 50. For example, the substrate heating device 200 may be a rapid thermal process (RTP) apparatus that generates high temperature heat to rapidly perform heat treatment on the substrate 50, and the substrate 50 may be a silicon wafer used in a semiconductor device or various object to be processed requiring heat treatment (e.g., glass applied to a display device such as LCD and OLED).

Here, the substrate heating device 200 in accordance with an exemplary embodiment may further include a chamber 240 having an internal space, and the chamber 240 may provide a process space separated from the external space due to the internal space and have a box shape. For example, the substrate supporter 210 may be installed in the internal space of the chamber 240 to support the substrate 50, and an entrance through which the substrate 50 is loaded and unloaded may be defined at one side of the chamber 240. Here, the substrate 50 may be loaded into the internal space of the chamber 240 through the entrance, and after the process is completed, the substrate 50 may be unloaded from the internal space of the chamber 240 to the outside of the chamber 240 through the entrance. As necessary, a gas supply unit (not shown) for supplying a process gas into the internal space of the chamber 240 and/or a plasma generation unit (not shown) for activating the process gas may be connected to the chamber 240.

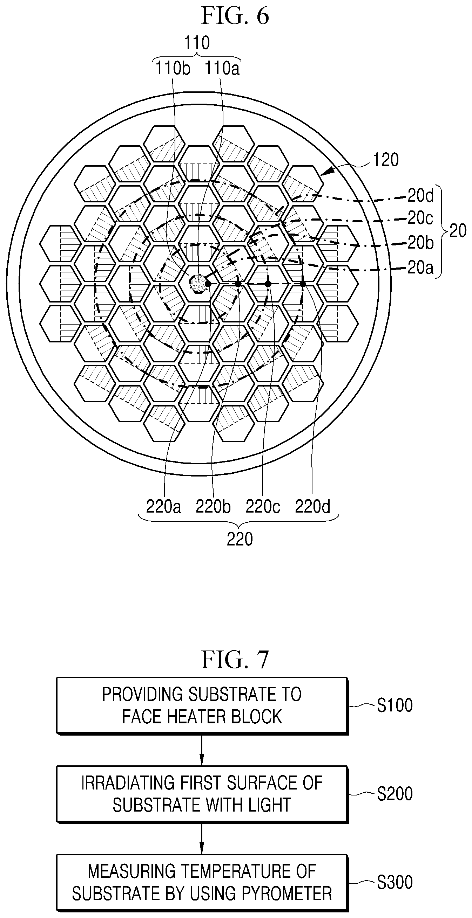

FIG. 6 is a cross-sectional view illustrating arrangement of a pyrometer according to another embodiment of the present invention.

Referring to FIG. 6, the substrate heating device 200 according to the present invention may further include a pyrometer 220 disposed at a second surface side of the substrate 50, which is opposite to the first surface, to measure a temperature of the substrate 50.

The pyrometer 220 may be disposed at the second surface side (e.g., bottom surface) of the substrate 50 (e.g., a lower side of the substrate), which faces the first surface to measure the temperature of the substrate 50. The pyrometer 220 may measure the temperature by detecting light incident from the substrate 50. For example, the pyrometer 220 may receive radiant light incident from the substrate 50 and measure radiant energy (or light quantity) of the radiant light and be disposed at the lower side of the substrate 50 seated on the substrate support 210 to obtain the radiant energy and a reflectance from a facing portion, thereby measuring the temperature for each position (or each portion) of the substrate 50 at a corresponding position of (each of) the pyrometer 220. Here, a process of measuring a temperature by the pyrometer 220 using light emitted from an object uses the blackbody radiation theory. Since the process is well-known, a detailed description thereof will be omitted.

In general, the pyrometer 220 measures a temperature using a wavelength band of 0.9 µm to 1 µm, a measurement (temperature) range is about 400°C to 1,150°C, and a transmittance of the substrate 50 for light in a wavelength band of 0.9 um to 1 µm has characteristics that depend on the temperature of the substrate 50. For example, a silicon wafer has a translucent transmittance at a temperature of 600°C or less and transmits light in a low temperature range due to material properties thereof. Due to the above-described characteristics, when the substrate 50 has a low temperature of 600°C or less, a portion of light emitted from a halogen lamp having a radiation wavelength of 0.4 µm to 6 µm is transmitted through the substrate 50. As a result, in case of the substrate 50 having the low temperature, a portion of the light emitted from the halogen lamp having the radiation wavelength of 0.4 µm to 6 µm is transmitted through the substrate, and the pyrometer 220 having a measurement wavelength band of 0.9 µm to 1 µm measures a portion of the transmitted light. Thus, the pyrometer 220 may not accurately measure the temperature of the substrate 50 to cause a temperature measurement error.

In order to solve the above-described limitation, the substrate heating device 200 according to the present invention may use the first laser module 110 and the second laser module 120 each including the plurality of laser cells 10 having a main emission wavelength shorter than the measurement wavelength of the pyrometer 220 as light sources, and the VCSEL may be used in the laser cell 10.

A semiconductor laser diode (or semiconductor laser) of the laser cell 10, which is a device that emits a coherent laser beam from a junction when a voltage is applied to both ends, has a structure in which an active region is inserted between a PN junction and emits light at a wavelength determined by a thickness and composition of the active region. Thus, the semiconductor laser diode may emit light having a predetermined wavelength when the thickness and composition of the active region are varied.

Since the silicon wafer has a translucent transmittance at a temperature of 600°C or less, the light emitted from the first laser module 110 and the second laser module 120 may also be transmitted through the silicon wafer and reached at the pyrometer 220 as with the light of the halogen lamp. However, since the main emission wavelength of each of the first laser module 110 and the second laser module 120 is shorter than the measurement wavelength of the pyrometer 220, the light emitted from the first laser module 110 and the second laser module 120 may be excluded from the light quantity measured by the pyrometer 220. Thus, the light quantity measured by the pyrometer 220 may only include a quantity of light radiated or reflected from the substrate 50. For example, when the first laser module 110 and the second laser module 120 each having the emission wavelength of 0.85 µ m are used as the light sources, although the light transmitted through the silicon wafer at 600°C or less reaches the pyrometer 220, the temperature of the substrate 50 may not be accurately measured because the light that is deviated from the measurement wavelength of 0.9 µm to 1 µm may be excluded to the light quantity measured by the pyrometer 220.

Although the LED may also emit light having various wavelengths by changing the composition of the active region, the LED is not appropriate because a spectrum width of output light is 30 nm to 120 nm, which is relatively wide, and there is a high possibility of generating a band overlapping 0.9 µm to 1 µm that is the measurement wavelength of the pyrometer 220. Although the emission wavelength of the LED is required to be further shorter than that of visible or ultraviolet light so as not to overlap the measurement wavelength band of the pyrometer 220, the light having a short wavelength is not effective for transmitting thermal energy more than infrared light having a wavelength of 850 nm.

However, a semiconductor laser diode (LD) may have a spectrum width of output light, which is generally much narrower than 1 nm, and even a multimode laser diode (LD) may also have a spectrum width of output light, which is a narrow spectrum width of about 3 nm to 10 nm. Thus, the LD may obtain a wavelength band of output light that is not in overlap with 0.9 nm to 1 nm, which is the measurement wavelength of the pyrometer 220 while using infrared light (e.g.**,** infrared light having a wavelength of 850 nm).

Here, pyrometers 220 may be provided in plurality to correspond to a plurality of virtual circles 20, respectively, which have different radii centered on the first laser module 110. The pyrometer 220 may be provided in plurality, and the plurality of pyrometers 220 may be disposed respectively corresponding to the plurality of virtual circles 20 with different radii centered on the first laser module 110 (or concentric with a center of the first laser module). Accordingly, the temperature may be measured for each portion (or each position) of the substrate 50 corresponding to each area divided according to distances from the center of the heater block 100 (or the center of the first laser module). That is, the plurality of pyrometers 220 face areas divided according to the distances from the center of the heater block 100 for each portion (or each position) of the substrate 50 that is (mainly) heated by each area. Through this, the heating temperature of each area (the control area(s)) is controlled according to the temperature of each portion of the substrate 50 measured by the plurality of pyrometers 220 so that the temperatures for each portion of the substrate 50 is uniform during the process.

Here, the substrate 50 may have a circular shape, and the substrate heating device 200 in accordance with an exemplary embodiment may further include a rotation driving unit (not shown) that rotates the substrate 50.

The rotation driving unit (not shown) may rotate the substrate 50 to further uniformize the temperature of the substrate 50, rotate the substrate support 210 to rotate the substrate 50 together with the substrate support 210, or rotate only the substrate 50 on the substrate supporter 210.

In an exemplary embodiment, since the substrate 50 has a circular shape, the first laser module 110 may be divided into the central control area 110a and the edge control area 110b to form a concentric circle around the first laser module 110, the first control area(s) 120a and the second control area(s) 120b passing through (or crossing) the same concentric circle (with the same radius) may be grouped, and the plurality of pyrometers 220 may be arranged to respectively correspond to the plurality of virtual circles 20 having different radii. Here, the pyrometers 220 may be arranged one by one to correspond to each of the plurality of virtual circles 20 and measure the temperature of a wide (ring-shaped) portion of the substrate 50 extending along the virtual circle 20 by rotating the substrate 50 by the rotation driving unit (not shown). That is, the wide portion of the substrate 50 extending along the virtual circle 20 may pass (all) the pyrometer 220 (a position of the pyrometer) while the substrate 50 is rotated, and temperatures of the wide portion of the substrate 50 extending along the virtual circle 20 may be measured with a single pyrometer 220.

Here, as one virtual circle 20 is set for each shell (or layer) of the first laser module 110 and/or the second laser module 120, one (each) pyrometer 220 may be disposed in correspondence to each virtual circle 20. Alternatively, one virtual circle 20 is set for the central control area 110a and the edge control area 110b of the first laser module 110 and/or each group of first control area 120a and each group of the second control area 120b of the plurality of second laser module 120. However, the exemplary embodiment is not limited to the setting of the plurality of virtual circles 20 and arrangement of the plurality of pyrometers 220. For example, the plurality of virtual circles 20 and the plurality of pyrometers 220 may be variously set and arranged. All sorts of setting and arrangement are satisfied as long as the temperatures for each portion of the substrate 50 is uniform during the process by measuring the temperatures for each portion of the substrate 50 and controlling the heating temperature for each area (or each group).

For example, the pyrometer 220 may include a first pyrometer 220a disposed in correspondence to a first virtual circle 20a, a second pyrometer 220b disposed in correspondence to a second virtual circle 20b, a third pyrometer 220c disposed in correspondence to a third virtual circle 20c, and a fourth pyrometer 220d disposed in correspondence to a fourth virtual circle 20d. The first pyrometer 220a may be disposed in correspondence to the first virtual circle 20a and disposed between (on a boundary of) the central control area 110a and the edge control area 110b of the first laser module 110. Also, the second pyrometer 220b may be disposed in correspondence to the second virtual circle 20b and disposed between the group (or a concentric circle formed by the group) of the first control area 120a and the group (or a concentric circle formed by the group) of the second control area 120b of the second laser module 120 of the first shell.

Also, the third pyrometer 220c may be disposed in correspondence to the third virtual circle 20c and disposed between the group (or a concentric circle formed by the group) of the first control area 120a and the group (or a concentric circle formed by the group) of the second control area 120b of the second laser module 120 of the double shell. Also, the fourth pyrometer 220d may be disposed in correspondence to the fourth virtual circle 20d and disposed between the group (or a concentric circle formed by the group) of the first control area 120a and the group (or a concentric circle formed by the group) of the second control area 120b of the second laser module 120 of the triple shell.

The substrate heating device 200 according to the present invention may further include a heating control unit 230 controlling each control area 110a, 110b, 120a, and 120b according to distances from each virtual circle 20 based on a temperature measured by each of the plurality of pyrometers 220.

The heating control unit 230 may control each control area 110a, 110b, 120a, and 120b according to the distances from each virtual circle 20 based on the temperature measured by each of the plurality of pyrometers 220 and control power supplied to each control area 110a, 110b, 120a, and 120b by using the measured temperature. Here, the plurality of pyrometers 220 may calculate the temperature by measuring a quantity of light incident from the substrate 50, and the heating control unit 230 may control power inputted to each control area 110a, 110b, 120a, and 120b by using the measured temperature.

For example, the heating control unit 230 may include a temperature setting unit 231 for setting a target temperature of the substrate 50 and a power determination unit 232 that determines a power supply value by comparing the temperature measured by the pyrometer 220 with the target temperature set by the temperature setting unit 231. The temperature setting unit 231 may set the target temperature of the substrate 50 and the temperature of the substrate 50 to be obtained through heating of the heater block 100.

The power determination unit 232 may determine the power supply value by comparing the target temperature set by the temperature setting unit 231 with the temperature measured by the pyrometer 220 and supply the determined power to the first power source part 130 and/or the second power source part 140. Through this, the heating temperature of the area may be controlled (or adjusted) by supplying the determined power to the area (the control area(s) of the area) (of the heater block) corresponding to (or facing) a portion of the substrate 50 measured by the pyrometer 220 and compensate (or correct) the temperature (difference) of the portion of the substrate 50 measured by the pyrometer 220.

Although the heating control unit 230 may simultaneously control the entire first laser module 110 and/or the entire second laser module 120 according to the measured temperature, the heating control unit 230 may independently adjust operations and power supply for each of the plurality of groups (e.g., the central control area and the edge control area, and the group of the first control area and the group of the second control area) according to the temperature for each portion of the substrate 50 corresponding to the position of each of the plurality of pyrometers 220.

Also, the heating control unit 230 may control the heating temperature of two or more groups by using the temperature measured by one pyrometer 220. For example, the heating temperature of the central control area 110a and the edge control area 110b may be controlled by the temperature measured by the first pyrometer 220a disposed between the central control area 110a and the edge control area 110b of the first laser module 110. Also, the heating temperature of the group of the first control area 120a and the group of the second control area 120b of the second laser module 120 of the first shell may be controlled by using the temperature measured by the second pyrometer 220b disposed between the group of the first control area 120a and the group of the second control area 120b of the second laser module 120 of the first shell. Also, the heating temperature of the group of the first control area 120a and the group of the second control area 120b of the second laser module 120 of the double shell may be controlled by using the temperature measured by the third pyrometer 220c disposed between the group of the first control area 120a and the group of the second control area 120b of the second laser module 120 of the double shell. Also, the heating temperature of the group of the first control area 120a and the group of the second control area 120b of the second laser module 120 of the triple shell may be controlled by using the temperature measured by the fourth pyrometer 220d disposed between the group of the first control area 120a and the group of the second control area 120b of the second laser module 120 of the triple shell.

Here, an area provided by the first laser module 110 and the second laser module 120 of the heater block 100 may be greater than that of the substrate 50 to compensate for heat loss outside the substrate 50, and the pyrometer 220 may only measure within the area of the substrate 50 not to control the heating temperature of the control areas 110a, 110b, 120a, and 120b deviated from the area of the substrate 50 when controlling only the heating temperature of the area facing (or corresponding to) the portion of the substrate 50 measured by the pyrometer 220. Thus, when the fourth pyrometer 220d is the outermost pyrometer 220 that measures the temperature of the substrate 50 within the area of the substrate 50, the heating temperature of the group of the first control area 120a and the group of the second control area 120b of the second laser module 120 of the triple shell and the heating temperature of the group of the first control area 120a and the group of the second control area 120b of the second laser module 120 of the n-layer shell such as the quadruple shell may also be controlled by using the temperature measured by the fourth pyrometer 220d.

Here, the heating temperature control (or controlled heating temperature) of the central control area 110a and the edge control area 110b and/or the group of the first control area 120a and the group of the second control area 120b may be varied depending on the distances from each virtual circle 20.

Also, the temperature measurement of the substrate 50 by the pyrometer 220 may be performed even in a temperature range lower than 600°C.

In recent years, a new material such as nickel silicide (NiSi) is required to reduce leakage current and resistance of a shallow junction in a new semiconductor device such as Nano-CMOS and FinFET. A low-temperature process at a temperature equal to or less than 600°C is required to deposit a thin-film such as nickel silicide.

In general, when using a halogen lamp or semiconductor light-emitting diode (LED) used as a light source for heating, the pyrometer 220 may not accurately measure the temperature in a low temperature range of 600°C or less. Accordingly, a complex process such as a process of additionally installing another unit capable of measuring a temperature even in the low temperature range of 600°C or less to the substrate heating device 200 is required, and thus, the substrate heating device 200 may have a complex structure.

However, the substrate heating device 200 according to the present invention may precisely measure even the temperature lower than 600°C by using the laser cell 10 having a main emission wavelength shorter than the measurement wavelength of the pyrometer 220 as the heating light source to handle all processes in a wide temperature range from the low-temperature process lower than 600°C to a high-temperature process without using the additional temperature measurement unit.

Thus, the substrate heating device 200 including the heater block 100 according to the present invention may control the heating temperature of the first laser module 110 and the second laser module 120 for each group (or for each control area) by using the temperature measured by the pyrometer 220 to improve the temperature uniformity of the substrate 50 during the process. Particularly, as the control area is subdivided by dividing at least one of the first laser module 110 and the second laser module 120 into a plurality of control areas 110a, 110b, 120a, and 120b, the temperature uniformity of the substrate 50 may be further improved. Here, as the plurality of pyrometers 220 are provided to correspond to the plurality of virtual circles 20 having different radii that are different in distance from the first laser module 110, and the first control area 120a and the second control area 120b of the plurality of second laser modules 120 are grouped according to the distances from the first laser module 110, the plurality of first control areas 120a and the plurality of second control areas 120b may be controlled for each group that forms a concentric circle centered on the first laser module 110. Through this, the plurality of first control areas 120a and the plurality of second control areas 120b may be precisely controlled for each group according to the distances from each virtual circle 20 based on the temperature measured by each of the plurality of pyrometers 220, and thus process characteristics such as excellent temperature uniformity of the substrate 50 may be improved.

Also, when the VCSEL is used in the laser cell 10 of the heater block 100, the temperature of the substrate 50 may be accurately measured even in the low temperature area lower than 600°C by irradiating a laser having a main emission wavelength band different from the measurement wavelength band of the pyrometer 220, and the temperature of the substrate 50 may be precisely controlled. Thus, the substrate 50 may be prevented from being damaged by securing the temperature uniformity of the substrate 50, and reliability of the low-temperature process at a temperature equal to or less than 600°C may be secured.

FIG. 7 is a flowchart representing a method for heating a substrate according to yet another embodiment of the present invention.

Hereinafter, the method for heating the substrate according to yet another exemplary embodiment of the present invention will be described in more detail with reference to FIG. 7, and features duplicated with those described in the heater block according to an embodiment of the present invention and the substrate heating device according to another exemplary embodiment of the present invention will be omitted.

The method for heating the substrate according to yet another exemplary embodiment of the present invention may include a process S100 of providing the substrate facing a heater block including a first laser module and a second laser module each independently supplied with power; a process S200 of irradiating a first surface of the substrate facing the heater block using with light by using the first laser module and the second laser module; and a process S300 of measuring a temperature of the substrate by using a pyrometer disposed on a second surface of the substrate facing the first surface.

Firstly, the substrate is provided to face the heater block including the first and second laser modules each independently supplied with the power in the process S100. The substrate may be provided to face the heater block including the first laser module and the second laser module each independently supplied with the power, and the substrate may be supported on a substrate support disposed to face the heater block. For example, as the substrate supporter is installed in an internal space of a chamber to support the substrate, the substrate may be provided in a process space of the chamber, and the substrate may be loaded into the internal space of the chamber through an entrance defined in one side of the chamber.

Thereafter, the first surface of the substrate facing the heater block is irradiated with light by using the first laser module and the second laser module in the process S200. The first surface of the substrate facing the heater block may be irradiated with light by using the first laser module and the second laser module, the first surface of the substrate may be irradiated with light (optical energy of the light) emitted from a laser cell of each of the first laser module and the second laser module, and the optical energy may be converted into thermal energy to increase a temperature of the substrate. Here, the laser cell may include a vertical-cavity surface-emitting laser (VCSEL). Here, the optical energy of the light emitted from the first laser module and the second laser module may be determined depending on an amount of power supplied from each of first and second power sources to each of the first laser module and the second laser module.

Thereafter, the temperature of the substrate is measured by using the pyrometer provided on the second surface of the substrate facing the first surface in the process S300. The temperature of the substrate may be measured by using the pyrometer provided on the second surface of the substrate, and the pyrometer may measure the temperature by using radiant energy of light incident from the substrate. Here, a main emission wavelength of the laser cell may be shorter than a measurement wavelength of the pyrometer.

At least one of the first laser module and the second laser module may be divided into a plurality of control areas that are controlled independently from each other. At least one laser module of the first laser module and the second laser module may include a plurality of input terminals and be divided into a plurality of control areas each having the input terminal. Here, the plurality of control areas may include at least laser cell sharing each of the input terminals and be controlled independently from each other depending on the input terminal to which the power is supplied.

The first laser module may be divided into a central control area and an edge control area, and the second laser module may be bisected into a first control area and a second control area. The first laser module may be concentrically divided into the central control area and the edge control area, the central control area may be provided at the inside and disposed at a center of the heater block, and the edge control area may disposed outside the central control area. Thus, the control area may be subdivided in a radial direction from the center of the heater block even within the first laser module.

The second laser module may be radially bisected into the first control area and the second control area, and he first control area and the second control area may be symmetric to each other and have the same shape and area and the same number of laser cells. For example, when the second laser module has a hexagonal shape, the first control area and the second control area may be bisected based on a line connecting vertices of the hexagon or a line connecting sides thereof.

Here, the second laser module may be provided in plurality and arranged around the first laser module by using the first laser module as a center, so that distances from each of the first control area and the second control area to the first laser module are different. The second laser module may be provided in plurality and arranged around the first laser module by using the first laser module as the center and surround the first laser module along a circumference of the first laser module. For example, only one first laser module may be disposed at the center (or central portion) of the heater block, and the plurality of second laser modules may be disposed at an edge of the heater block to surround the circumference of the first laser module. Here, although the second laser module may surround the first laser module with only one shell, the second laser module may surround the first laser module with multiple shells such as a double shell and triple shell which form a concentric circle around the first laser module according to a size and shape of the substrate and/or the heater block. Through this, the control area may be subdivided in the radial direction from the center of the heater block.

Also, the first control area and the second control area may be provided at different distances from the first laser module, one of the first control area and the second control area may be provided close to the first laser module, and the other control area may be provided far from the first laser module. For example, the plurality of second laser modules may be disposed around the first laser module so that the first control area is disposed close to the first laser module toward the first laser module, and the second control area is disposed relatively far from the first laser module in an outward direction (radius direction).

The method for heating the substrate according to the present invention may further include a process S400 of grouping and controlling respectively the first control area and the second control area of the plurality of second laser modules according to the distance from the first laser module.

Also, the first control area and the second control area of the plurality of second laser modules may be respectively grouped and controlled according to the distance from the first laser module. A heating control unit may group and control the first control area and the second control area of the plurality of second laser modules according to the distance from the first laser module and control a heating temperature of the grouped first control area and the grouped second control area to uniformize temperatures for each portion of the substrate during a process. The first control area and the second control area of the plurality of second laser modules may be grouped according to the distance from the first laser module to: form a concentric circle around the first laser module; efficiently (or effectively) control the plurality of first control areas (i.e., the group of the first control areas) and the plurality of second control areas (i.e., the group of second control areas) for each group passing through the same concentric circle; and improve temperature uniformity of the substrate through heating.

As the first control area and the second control area are grouped, a plurality of pyrometers may be provided to correspond to a plurality of virtual circles with different radii centered on the first laser module, respectively. As the first control area and the second control area are grouped, the plurality of pyrometers may be provided to correspond to the plurality of virtual circles with different radii centered on the first laser module, respectively. For example, the pyrometer may be provided in plurality, and the plurality of pyrometers may be disposed corresponding to the plurality of virtual circles with different radii centered on the first laser module (or using the center of the first laser module as a center of the concentric circle), respectively. Accordingly, the temperature may be measured for each portion (or each position) of the substrate corresponding to each area (or the control areas of each area) divided according to the distance from the center of the heater block (or the center of the first laser module). Here, as the first control area and the second control area are grouped to smoothly control the group of the first control area and the group of the second control area for the temperature uniformity for each portion of the substrate during the process, the plurality of virtual circles may be set, and the plurality of pyrometers may correspond to the plurality of virtual circles.

Also, the process S400 of grouping and controlling may control each control area for each group according to the distance from each virtual circle based on the temperature measured by each of the plurality of pyrometers. The heating control unit may control each control area for each group according to the distance from each virtual circle based on the temperature measured by each of the plurality of pyrometers, and the power supplied to each control area may be controlled by using the measured temperature. Here, the plurality of pyrometers may calculate the temperature by measuring an amount of light incident from the substrate, and the heating control unit may control power inputted to each control area by using the calculated temperature.

For example, the process S400 of grouping and controlling includes a process S410 of setting a target temperature of the substrate and a process S420 of determining a supply power value by comparing the set target temperature with the measured temperature.

The target temperature of the substrate may be set in the process S410. The target temperature of the substrate may be set through a temperature setting unit, and the temperature of the substrate to be obtained through heating by the heater block may be set.

Also, a supply power value may be determined by comparing the set target temperature with the measured temperature in the process S420. The process S410 of setting the target temperature by the power determination unit may determine the supply power value by comparing the target temperature set in the temperature setting unit with the temperature measured by the pyrometer and supply the determined power to the first power source part and/or the second power source part. Through this, the heating temperature of the area may be controlled (or adjusted) by supplying the determined power to the area (the control area(s) of the area) (of the heater block) corresponding to (or facing) a portion of the substrate measured by the pyrometer and compensate (or correct) the temperature (difference) of the portion of the substrate measured by the pyrometer.

Thus, the method for heating the substrate according to the present invention may control the heating temperature of each area (or the control area(s) of each area) according to the temperature of each portion of the substrate measured by the plurality of pyrometer by measuring the temperature for each portion (or each position) of the substrate corresponding to each area (or the control area(s) of each area) divided according to the distance from the center of the heater block (or the center of the first laser module) through the plurality of pyrometers. Accordingly, the temperature may be precisely adjusted for each portion (of the radial direction) divided according to the distance from the center of the (circular) substrate, and the temperature uniformity of the substrate may be improved by uniformizing the temperature for each portion of the substrate during the process.

On the other hand, each process(es) of a method for heating a substrate in accordance with another exemplary embodiment is not necessarily performed in a chronological order, and each process(es) may be performed in the opposite order or at the same time as necessary. For example, after the process S300 of measuring the temperature of the substrate, the process S200 of irradiating the first surface of the substrate with light may be performed. Also, a plurality of processes may be repeatedly performed, or only a process(es) selected from among the plurality of processes may be repeatedly performed.

As described above, in the present invention, the power is independently supplied to the first laser module and the second laser module, respectively, through the first and second power supply parts, so that the first laser module and the second laser module may be controlled independently from each other. Thus, the heating temperature may be adjusted for each position of the first laser module and the second laser module, and the heating uniformity of the object to be heated such as a substrate may be improved. Also, as at least one of the first laser module and the second laser module is divided into the plurality of control areas and controlled independently from each other, the control areas may be subdivided, and the heating uniformity for the object to be heated may be further improved. Here, as the divided shape of the control area between the first laser module and the second laser module is differentiated into concentric division and radial division, the heating temperature may be precisely controlled by subdividing the control area in the radial direction from the center of the heater block. Here, as the first control area and the second control area of the second laser module disposed around the first laser module are arranged at different distances from the first laser module, and the first control area and the second control area of the plurality of second laser modules are grouped according to the distance from the first laser module, the plurality of first control areas and the plurality of second control areas may be efficiently controlled for each group forming the concentric circle centered on the first laser module. Thus, the temperature uniformity of the object to be heated through the heating may be improved. Also, the power consumption may be reduced in comparison with the conventional halogen lamps due to high energy efficiency by using a Vertical-Cavity Surface-Emitting Laser (VCSEL) in the laser cell, and the optical property may be effectively controlled due to the light straightness and the easiness of emitting light having a specific wavelength. And, the temperature uniformity of the substrate during the process may be improved by controlling the heating temperature of the first laser module and the second laser module using the temperature measured by the pyrometer. Particularly, as the control area is subdivided by dividing at least one of the first laser module and the second laser module into the plurality of control areas, the temperature uniformity of the substrate may be further improved. Here, the pyrometer is provided in plurality to provide the plurality of pyrometers so as to respectively correspond to the plurality of virtual circles having different radii that are different in distance from the first laser module, and the plurality of first control areas and the plurality of second control areas may be controlled for each group that forms a concentric circle centered on the first laser module by respectively grouping the first control area and the second control area of the plurality of second laser modules according to the distance from the first laser module. Through this, the plurality of first control areas and the plurality of second control areas may be precisely controlled for each group according to the distance from each virtual circle based on the temperatures respectively measured by the plurality of pyrometers, and thus the process characteristics such as excellent temperature uniformity of the substrate may be improved. Meanwhile, when the Vertical-Cavity Surface-Emitting Laser (VCSEL) is used in the laser cell of the heater block, the temperature of the substrate may be accurately measured even in the low temperature area lower than 600°C by irradiating the laser having the main emission wavelength band different from the measurement wavelength band of the pyrometer, and the temperature of the substrate may be precisely controlled. Thus, the substrate may be prevented from being damaged by securing the temperature uniformity of the substrate and reliability of the low-temperature process at the temperature equal to or less than 600°C may be secured.

In the specification, it will be understood that when a layer (or film) is referred to as being 'on' another layer or substrate, it can be directly on the other layer or substrate, or intervening layers may also be present.

Although the exemplary embodiments of the present invention have been described, it is understood that the present invention should not be limited to these exemplary embodiments but various changes and modifications can be made by one ordinary skilled in the art within the spirit and scope of the present invention as hereinafter claimed. Hence, the real protective scope of the present invention shall be determined by the technical scope of the accompanying claims.

## Claims

1. A heater block comprising:
a first laser module having a plurality of laser cells;
a second laser module having a plurality of laser cells and disposed around the first laser module; and
a first and a second power source part configured to independently supply power to the first and second laser modules, respectively,
wherein at least one of the first laser module and the second laser module is divided into a plurality of control areas each composed of one or more laser cells sharing an input terminal to which the power is inputted, and
the plurality of control areas are controlled independently from each other.

2. The heater block of claim 1, wherein the first laser module and the second laser module have different divided shapes of the control areas.

3. The heater block of claim 1, wherein the second laser module is provided in plurality and arranged around the first laser module by using the first laser module as a center.

4. The heater block of claim 3, wherein the first laser module is divided into a central control area and an edge control area, and
the second laser module is bisected into a first control area and a second control area.

5. The heater block of claim 4, wherein the first control area and the second control area are disposed at different distances from the first laser module.

6. The heater block of claim 5, wherein the first control areas and the second control areas of the plurality of second laser modules are respectively grouped according to the distances from the first laser module.

7. The heater block of claim 6, wherein the first power source part independently supplies power to each of the central control area and the edge control area, and
the second power source part independently supplies power to each of a group of the first control area and a group of the second control area.

8. The heater block of claim 1, wherein each of the first laser module and the second laser module has a polygonal shape.

9. The heater block of claim 1, wherein the laser cell comprises a vertical-cavity surface-emitting laser (VCSEL).

10. The heater block of claim 1, further comprising a reflector unit configured to reflect at least a portion of light emitted from the first laser module and the second laser module in a predetermined direction by surrounding an edge of each of the first laser module and the second laser module.

11. A substrate heating device comprising:
a substrate support configured to support a substrate; and
the heater block of any one of claims 1 to 10, which is disposed to face the substrate support and heats the substrate by irradiating a first surface of the substrate with light.

12. The substrate heating device of claim 11, further comprising a pyrometer disposed at a second surface side of the substrate, which is opposite to the first surface, to measure a temperature of the substrate.

13. The substrate heating device of claim 12, wherein the pyrometer is provided in plurality, and the plurality of pyrometers are disposed respectively corresponding to a plurality of virtual circles with different radii centered on the first laser module.

14. The substrate heating device of claim 13, further comprising a heating control unit configured to control each of the control areas according to a distance from each of the virtual circles based on a temperature measured by each of the plurality of pyrometers.

15. A method for heating a substrate, the method comprising:
providing the substrate to face a heater block comprising a first laser module and a second laser module, to which power is each independently supplied;
irradiating a first surface of the substrate, which faces the heater block, with light by using the first laser module and the second laser module; and
measuring a temperature of the substrate by using a pyrometer disposed at a second surface side of the substrate, which is opposite to the first surface,
wherein at least one of the first laser module and the second laser module is divided into a plurality of control areas controlled independently from each other.

16. The method of claim 15, wherein the first laser module is divided into a central control area and an edge control area,
the second laser module is bisected into a first control area and a second control area, and
the second laser module is provided in plurality and arranged around the first laser module by using the first laser module as a center so that distances from the first laser module to each of the first control area and the second control area are different.

17. The method of claim 16, further comprising grouping and controlling respectively the first control areas and the second control areas of the plurality of second laser modules according to the distances from the first laser module.

18. The method of claim 17, wherein a plurality of pyrometers are disposed respectively corresponding to a plurality of virtual circles with different radii centered on the first laser module according to the grouping of the first control areas and the second control areas, and
the grouping and controlling controls each of the control areas for each group according to a distance from each of the virtual circles based on a temperature measured by each of the plurality of pyrometers.
